# EUROPEAN PATENT APPLICATION

(11) **EP 3 795 980 A1**
(43) Date of publication of application: **24.03.2021**
(21) Application number: 19198395.6
(22) Date of filing: 19.09.2019
(51) Int. Cl.: G01N 21/17

(54) **PHOTOACOUSTIC APPARATUS AND METHODS**

(71) Applicant: Nokia Technologies Oy, 02610 Espoo (FI)
(72) Inventor: BITAULD, David, Cambridge, Cambridgeshire CB3 0BD (GB); STERN, Brian, Holmdel, NJ New Jersey 07733 (US)
(74) Representative: Swindell & Pearson Limited

(57) **Abstract**

A photoacoustic apparatus comprising means for generating a frequency comb of light comprising a plurality of wavelengths; means for modulating the light of the frequency comb at a modulation frequency; means for changing at least a subset of the plurality of wavelengths of the frequency comb of light; and at least one acoustic sensor configured to detect sound produced by analyte illuminated by the frequency comb of light.

## Description

### TECHNOLOGICAL FIELD

Embodiments of the present disclosure relate to a photoacoustic apparatus and methods. Some relate to a photoacoustic apparatus and associated methods in photoacoustic spectroscopy.

### BACKGROUND

Spectroscopy is a powerful technique with a wide range of applications, for example in environment and health analysis.

Spectroscopy using photoacoustic effect-based techniques is one of the most promising techniques for high sensitivity spectroscopy.

### BRIEF SUMMARY

The scope of protection sought for various embodiments of the invention is set out by the independent claims. The examples and features, if any, described in the specification that do not fall under the scope of the independent claims are to be interpreted as examples useful for understanding various embodiments of the invention.

According to various, but not necessarily all, embodiments of the invention there is provided a photoacoustic apparatus comprising:
means for generating a frequency comb of light comprising a plurality of wavelengths;
means for modulating the light of the frequency comb at a modulation frequency;
means for changing at least a subset of the plurality of wavelengths of the frequency comb of light; and
at least one acoustic sensor configured to detect sound produced by analyte illuminated by the frequency comb of light.

In some, but not necessarily all, examples the means for modulating the light of the frequency comb comprises means for modulating the wavelengths and/or amplitude of the light of the frequency comb.

In some, but not necessarily all, examples the means for generating a frequency comb of light comprises at least one tunable laser and means for manipulating light, and wherein the at least one tunable laser is configured to pump the means for manipulating light to generate the frequency comb of light.

In some, but not necessarily all, examples the means for manipulating light comprises at least one micro-resonator.

In some, but not necessarily all, examples the means for generating a frequency comb of light comprises a single tunable laser and a single micro-resonator.

In some, but not necessarily all, examples the at least one tunable laser and the means for manipulating light are combined on a single chip.

In some, but not necessarily all, examples the means for modulating the light of the frequency comb comprises means for controlling modulation of drive current and/or power of the tunable laser or lasers.

In some, but not necessarily all, examples the means for modulating the light of the frequency comb comprises at least one modulator configured to receive light and to modulate the light of the frequency comb of light.

In some, but not necessarily all, examples the means for changing at least a subset of the plurality of wavelengths of the frequency comb of light comprises:
means for changing wavelength output of the at least one tunable laser; and
means for tuning the means for manipulating light;
wherein the means for changing wavelength output of the at least one tunable laser and the means for tuning the means for manipulating light are configured to operate in coordination with each other.

In some, but not necessarily all, examples at least one of the means for changing wavelength output of the at least one tunable laser and the means for tuning the means for manipulating light comprises means for controlling temperature.

In some, but not necessarily all, examples the photoacoustic apparatus comprises means for spatially and/or temporally separating the plurality of wavelengths of light of the frequency comb into a plurality of sections.

In some, but not necessarily all, examples the means for modulating the light of the frequency comb are configured to modulate all wavelengths of light of the frequency comb at substantially the same frequency.

According to various, but not necessarily all, embodiments there is provided a system comprising:
at least one photoacoustic apparatus as described herein; and
means for measuring signal output from the at least one acoustic sensor.

According to various, but not necessarily all, examples there is provided a method comprising:
generating a frequency comb of light comprising a plurality of wavelengths;
modulating the light of the frequency comb at a modulation frequency;
measuring an acoustic signal generated by analyte illuminated by the modulated frequency comb of light;
changing at least a subset of the plurality of wavelengths of the frequency comb of light;
modulating the changed light of the frequency comb;
measuring an acoustic signal generated by analyte illuminated by the modulated changed frequency comb of light.

In some, but not necessarily all, examples changing at least a subset of the plurality of wavelengths of the frequency comb of light comprises changing, in coordination with each other, the wavelength output of at least one tunable laser and tuning of the means for manipulating light that generates a frequency comb of light when pumped by the at least one tunable laser.

In some, but not necessarily all, examples modulating the light of the frequency comb comprises modulating the wavelengths and/or amplitude of the light of the frequency comb.

In some, but not necessarily all, examples the generating a frequency comb of light comprises using at least one tunable laser and means for manipulating light, and wherein the at least one tunable laser is configured to pump the means for manipulating light to generate the frequency comb of light.

In some, but not necessarily all, examples the means for manipulating light comprises at least one micro-resonator.

In some, but not necessarily all, examples generating a frequency comb of light comprises using a single tunable laser and a single micro-resonator.

In some, but not necessarily all, examples the at least one tunable laser and the means for manipulating light are combined on a single chip.

In some, but not necessarily all, examples modulating the light of the frequency comb comprises controlling modulation of drive current and/or power of the tunable laser or lasers.

In some, but not necessarily all, examples the modulating the light of the frequency comb comprises using at least one modulator configured to receive light and to modulate the light of the frequency comb of light.

In some, but not necessarily all, examples at least one of the means for changing wavelength output of the at least one tunable laser and the means for tuning the means for manipulating light comprises means for controlling temperature.

In some, but not necessarily all, examples the method comprises spatially and/or temporally separating the plurality of wavelengths of light of the frequency comb into a plurality of sections.

In some, but not necessarily all, examples modulating the light of the frequency comb comprises modulating all wavelengths of light of the frequency comb at substantially the same frequency.

According to various, but not necessarily all, examples of the disclosure there is provided a method comprising:
providing means for generating a frequency comb of light comprising a plurality of wavelengths;
providing means for modulating the light of the frequency comb at a modulation frequency;
providing means for changing at least a subset of the plurality of wavelengths of the frequency comb of light; and
providing at least one acoustic sensor configured to detect sound produced by analyte illuminated by the frequency comb of light.

According to various, but not necessarily all, embodiments of the invention there is provided a photoacoustic apparatus comprising:
at least one generator configured to generate a frequency comb of light comprising a plurality of wavelengths;
at least one modulator configured to modulate the light of the frequency comb at a modulation frequency;
at least one tuner configured to change at least a subset of the plurality of wavelengths of the frequency comb of light; and
at least one acoustic sensor configured to detect sound produced by analyte illuminated by the frequency comb of light.

According to various, but not necessarily all, embodiments of the invention there is provided a photoacoustic apparatus comprising:
one or more components configured to generate a frequency comb of light comprising a plurality of wavelengths;
one or more components configured to modulate the light of the frequency comb at a modulation frequency;
one or more components configured to change at least a subset of the plurality of wavelengths of the frequency comb of light; and
at least one acoustic sensor configured to detect sound produced by analyte illuminated by the frequency comb of light.

According to various, but not necessarily all, embodiments of the invention there is provided a photoacoustic apparatus comprising:
at least one frequency comb generating apparatus configured to generate a frequency comb of light comprising a plurality of wavelengths;
at least one modulation control apparatus configured to modulate the light of the frequency comb at a modulation frequency;
at least one tuning apparatus configured to change at least a subset of the plurality of wavelengths of the frequency comb of light; and
at least one acoustic sensor configured to detect sound produced by analyte illuminated by the frequency comb of light.

### BRIEF DESCRIPTION

Some examples will now be described with reference to the accompanying drawings in which:
FIG. 1 shows an example of the subject-matter described herein;
FIGS. 2A and 2B show examples of the subject-matter described herein;
FIG. 3 shows an example of the subject-matter described herein;
FIG. 4 shows an example of the subject-matter described herein;
FIG. 5 shows an example of the subject-matter described herein;
FIG. 6 shows an example of the subject-matter described herein; and
FIG. 7 shows an example of the subject-matter described herein.

### DETAILED DESCRIPTION

Examples of the disclosure relate to a photoacoustic apparatus 10 and associated methods.

In examples, the photoacoustic apparatus 10 is an apparatus configured to be used in photoacoustic spectroscopy.

In some examples, the photoacoustic apparatus 10 comprises means 12 for generating a frequency comb 14 of light comprising a plurality of wavelengths, means 16 for modulating the light of the frequency comb 14 at a modulation frequency, means 18 for changing at least a subset of the plurality of wavelengths of the frequency comb 14 of light, and at least one acoustic sensor 20 configured to detect sound produced by analyte 22 illuminated by the frequency comb 14 of light.

Any suitable modulation can be used. For example, wavelength and/or amplitude modulation of the light of the frequency comb 14 can be used.

The plurality of wavelengths of light of the frequency comb 14 can, in some examples, be considered modes of the frequency comb 14 of light. Accordingly, in some examples the photoacoustic apparatus 10 can comprise means 16 for modulating, at a modulation frequency, the plurality of wavelengths of light/modes of the frequency comb 14.

In examples, analyte 22 can be considered to be any substance and/or material that is to be or is being analyzed using the photoacoustic apparatus 10. For example, analyte 22 can be a fluid, such as a gas, that is analyzed using the photoacoustic apparatus 10.

In examples, analyte 22 can be considered to be an analyte 22 or at least one analyte 22.

The photoacoustic apparatus 10 is advantageous as it provides a greater spectral range for photoacoustic spectroscopy. The photoacoustic apparatus 10 is configured to allow the wavelength range reached by the photoacoustic apparatus 10 to be increased to be, for example, in the hundreds of nanometre range. This increases the span or range of the photoacoustic apparatus system.

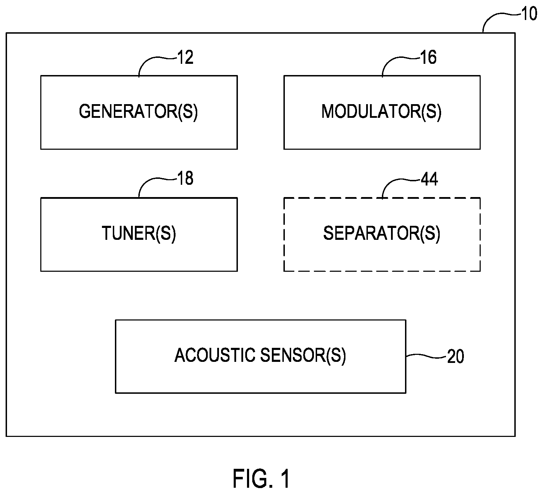

FIG. 1 schematically illustrates an example of a photoacoustic apparatus 10.

Various features referred to in relation to FIG. 1 can be found in the other figures.

The photoacoustic apparatus 10, of FIG. 1, comprises:
means 12 for generating a frequency comb 14 of light comprising a plurality of wavelengths;
means 16 for modulating the light of the frequency comb 14 at a modulation frequency; means 18 for changing at least a subset of the plurality of wavelengths of the frequency comb 14 of light; and
at least one acoustic sensor 20 configured to detect sound produced by analyte 22 illuminated by the frequency comb 14 of light.

In examples, the means 12 for generating a frequency comb 14 of light can comprise any suitable means for and/or configured to generate a frequency comb 14 of light comprising a plurality of wavelengths.

For example, the generation means 12 can comprise any suitable means for and/or configured to generate a frequency comb 14 of light comprising a plurality of wavelengths usable in photoacoustic spectroscopy.

In some, but not necessarily all, examples, the means 12 for generating a frequency comb 14 of light can be considered generation means 12.

In examples, the means 12 for generating a frequency comb 14 of light can be considered at least one frequency comb generator, at least one frequency comb generating arrangement, at least one frequency comb generating structure, at least one frequency comb generating device, at least one frequency comb generating apparatus and/or at least one frequency comb generating mechanism and so on.

In examples, the means 12 for generating a frequency comb 14 of light comprises a plurality of discrete and/or separate components configured to generate a frequency comb 14 of light.

In some examples, the frequency comb 14 produced by the means 12 for generating a frequency comb 14 of light comprises wavelengths in at least a portion of the range of ultra-violet to mid-infrared.

In examples the frequency comb 14 comprises wavelengths in at least a portion of the range 200 nanometers to 20 micrometers.

In some examples the frequency comb 14 comprises wavelengths in at least a portion of the range 500 nanometers to 15 micrometers.

In some examples the frequency comb 14 comprises wavelengths in at least a portion of the range 1 micrometer to 10 micrometers.

In examples, the means 12 for generating a frequency comb 14 of light comprises at least one light source configured to produce and/or provide light to at least one component and/or element to generate a frequency comb 14 of light.

The at least one light source can be configured to produce and/or provide light to generate a frequency comb 14 of light having wavelengths in the one or more of the ranges described above.

In examples, the at least one light source comprises at least one laser, for example, at least one tunable laser 26. In some examples, the means 12 for generating a frequency comb 14 of light comprises means 28 for manipulating light configured to receive light from a light source, such as at least one tunable laser 26, to generate the frequency comb 14 of light.

That is, in examples, the means 12 for generating a frequency comb 14 of light comprises at least one tunable laser 26 and means 28 for manipulating light, wherein the at least one tunable laser 26 is configured to pump the means 28 for manipulating light to generate the frequency comb 14 of light.

In some, but not necessarily all, examples, the means for manipulating light 28 can be considered light manipulation means 27.

Any suitable means 28 for manipulating light configured to generate a frequency comb 14 of light can be used. For example, the means 28 for manipulating light can comprise at least one free space cavity, at least one fibre cavity, at least one fibre-coupled micro-resonators and/or at least one chip-based micro-resonators and so on.

In examples, the means 28 for manipulating light can be considered to comprise one or more components configured to receive light, such as laser light, and generate a frequency comb 14 of light.

In examples, the means 28 for manipulating light can be considered light transformation and/or light conversion means.

In examples, the means 28 for manipulating light can comprise any suitable component or components configured to control and/or direct and/or affect and/or manipulate light.

In examples, the means 28 for manipulating light can be considered at least one light manipulator/transformer/convertor, at least one light manipulation/transformation/ conversion arrangement, at least one light manipulation/transformation/conversion structure, at least one light manipulating/transforming/converting device at least one light manipulating/transforming/converting apparatus and/or at least one light manipulation/transformation/converting mechanism and so on.

In examples, the means 28 for manipulating light comprises at least one micro-resonator 30.

In examples, the micro-resonator 30 comprises at least one micro-ring, at least one micro-toroid, at least one micro-sphere, at least one micro-disk, and/or at least one structure configured to generate whispering gallery modes and so on.

In examples the means 28 for manipulating light can be implemented on any suitable integrated photonic platform including Silicon, Silicon Nitride, Silicon Oxide, Germanium, Gallium Arsenide, Diamond, Aluminium Nitride, Lithium niobate and so on.

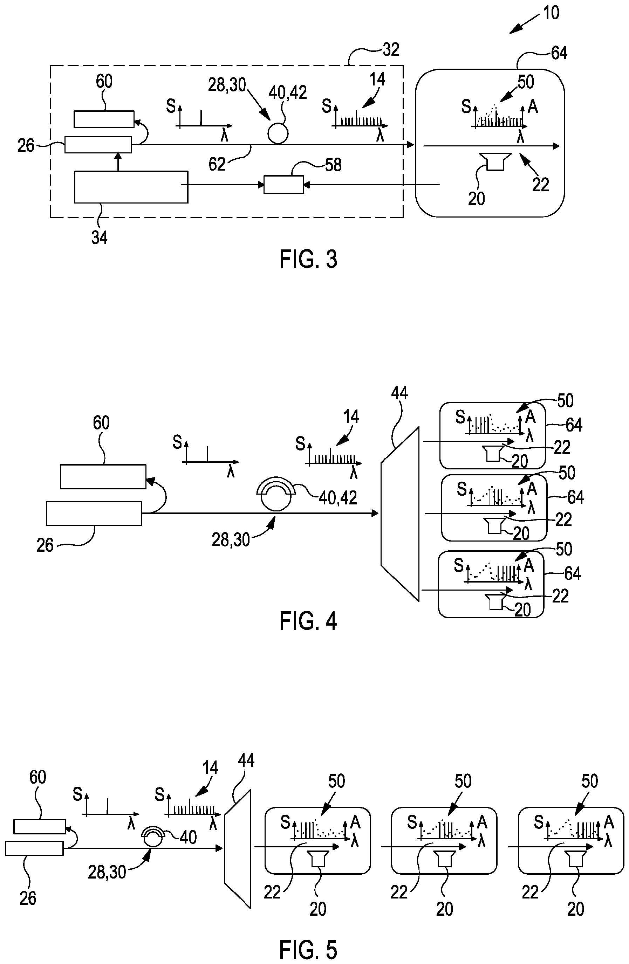

In examples, the means 12 for generating a frequency comb 14 of light comprises a single tunable laser 26 and a single micro-resonator 30. See, for example, FIG. 3, FIG.4 and FIG. 5.

In examples, the at least one tunable laser 26 and the means 28 for manipulating light are combined on a single chip 32. See, for example, FIG. 3.

Any suitable tunable laser or lasers 26 can be used.

In examples, a tunable pump laser 26 can be implemented by an inter-band cascade laser on a silicon chip.

In some examples a gain chip is coupled to a chip, such as a silicon chip. For example, the gain chip can be butt coupled to the chip by coupling the edges of the chips using waveguides.

In some examples, the gain chip can be coupled to the chip vertically using, for example, angled reflectors and/or grating couplers.

In some examples the chips are bonded onto a substrate, such as a silicon substrate.

In some examples the gain material can be epitaxially grown on a chip, such as a silicon chip.

Any suitable gain material/chip can be used. In examples the gain material/chip comprises III-V material.

The means 16 for modulating the light of the frequency comb 14 are configured to modulate the light of the frequency comb 14 at a modulation frequency.

In examples the plurality of wavelengths of light of the frequency comb 14 can be considered modes of the frequency comb. Accordingly, in some examples, the means 16 for modulating the light of the frequency comb 14 can be considered to be configured to modulate, at a modulation frequency, the plurality of modes of the frequency comb 14.

In some examples the means 16 for modulating the light of the frequency comb can be considered to be configured to modulate, at a modulation frequency, the plurality of wavelengths of light of the frequency comb 14.

Any suitable means for or configured to modulate the light of the frequency comb 14 at a modulation frequency can be used.

For example, the modulation means 16 can comprise any suitable means for or configured to modulate the light of the frequency comb 14 at a modulation frequency, to produce a photoacoustic effect.

In some, but not necessarily all, examples, the means 16 for modulating the light of the frequency comb 14 at a modulation frequency can be considered to be modulation means 16.

In examples, the means 16 for modulating the light of the frequency comb 14 are configured to modulate all wavelengths of light of the frequency comb 14 at substantially the same frequency.

In examples, the means 16 for modulating the light of the frequency comb 14 are configured to modulate each of the wavelengths of light of the frequency comb 14 at substantially the same frequency.

In examples, the means 16 for modulating the light of the frequency comb 14 can be considered at least one modulator, at least one modulator arrangement, at least one modulator structure, at least one modulator device, at least one modulator apparatus, at least one modulator mechanism, at least one modulation control apparatus, at least one modulation control device, and/or at least one modulation control mechanism and so on.

In examples, the means for modulating the light of the frequency comb 14 comprises one or more components configured to modulate a frequency comb 14 of light.

In examples, the means 16 for modulating the light of the frequency comb 14 comprises means for modulating the wavelengths and/or amplitude of the light of the frequency comb 14.

In examples, the modulation frequency is in the range 10Hz to 100kHz.

In some examples the modulation frequency can be chosen based on the type of acoustic sensor(s) 20 are used.
For example, a modulation frequency range of 10Hz to 100kHz can be used for cantilever or microphone based sensors.

A modulation frequency of approximately 16kHz can be used for quartz fork sensor(s) in relation to wavelength modulation.

A modulation frequency of approximately 32kHz can be used for quartz fork sensor(s) in relation to amplitude modulation.

In some examples, the means 16 for modulating the light of the frequency comb 14 comprises means 34 for controlling modulation of drive current and/or power of a tunable laser or lasers 26.

That is, in examples where the means 12 for generating a frequency comb 14 of light comprises at least one tunable laser the means 16 for modulating the light of the frequency comb 14 can comprise means 34 for controlling modulation of drive current and/or power of the tunable laser or lasers 26.

In examples controlling modulation of drive current and/or power of a tunable laser or lasers 26 provides amplitude and/or wavelength modulation.

In some, but not necessarily all, examples, the means 34 for controlling modulation of drive current and/or power of the tunable laser or lasers 26 can be considered control means.

In examples, any suitable means 34 for controlling modulation of a drive current and/or power of the tunable laser or lasers 26 can be used.

In examples, the means 34 for controlling modulation of drive current and/or power of a tunable laser or lasers 26 can be considered one or more modulation controllers, one or more modulation control arrangements, one or more modulation control structures, one or more modulation control devices, modulation control hardware, modulation control software, one or more modulation control mechanisms, modulation control circuitry and/or one or more modulation control apparatus, and so on.

In some examples the photoacoustic apparatus 10 comprises one or more additional or alternative controls configured to control the output of the tunable laser(s) 26.

In examples, the means 34 for controlling modulation of drive current and/or power of a tunable laser or lasers 26 comprises one or more components configured to control modulation of a drive current and/or power of the tunable laser or lasers.

In some examples a phase shifter in the laser 26 can be used to provide modulation.

In some examples, the means 16 for modulating the light of the frequency comb 14 comprises at least one modulator configured to receive light and to modulate the plurality of wavelengths of light of the frequency comb 14 of light. In some examples, the at least one modulator is configured to receive the frequency comb 14 of light and to modulate the plurality of wavelengths of the frequency comb 14 of light at a modulation frequency.

In examples, the at least one modulator can be one or more separate, discrete components.

In examples, one or more separate, discrete amplitude modulators can be used.

The means 18 for changing at least a subset of the plurality of wavelengths of the frequency comb 14 of light are configured to change the plurality of wavelengths of the frequency comb 14 of light.

Any suitable means 18 for changing at least a subset of the plurality of wavelengths of the frequency comb 14 of light can be used.

In some examples, the means 18 for changing at least a subset of the plurality of wavelengths of the frequency comb 14 of light are for and/or configured to shift the wavelength of the plurality of wavelengths of the frequency comb 14 of light.

In some, but not necessarily all, examples, the means 18 for changing at least a subset of the plurality of wavelengths of the frequency comb 14 of light can be considered tuning means 18.

In examples, the means 18 for changing at least a subset of the plurality of wavelengths of the frequency comb 14 of light can be considered at least one tuner, at least one tuning arrangement, at least one tuning structure, at least one tuning device, at least one tuning apparatus, and/or at least one tuning mechanism, and so on.

In examples, the means 18 for changing at least a subset of the plurality of wavelengths of the frequency comb 14 of light comprises one or more components configured to change and/or shift the wavelengths of a frequency comb 14 of light.

In examples, the means 18 for changing at least a subset of the plurality of wavelengths of the frequency comb 14 of light are for and/or configured to change the plurality of wavelengths of the frequency comb 14 of light by changing and/or moving and/or shifting the modes of the frequency comb 14 of light.

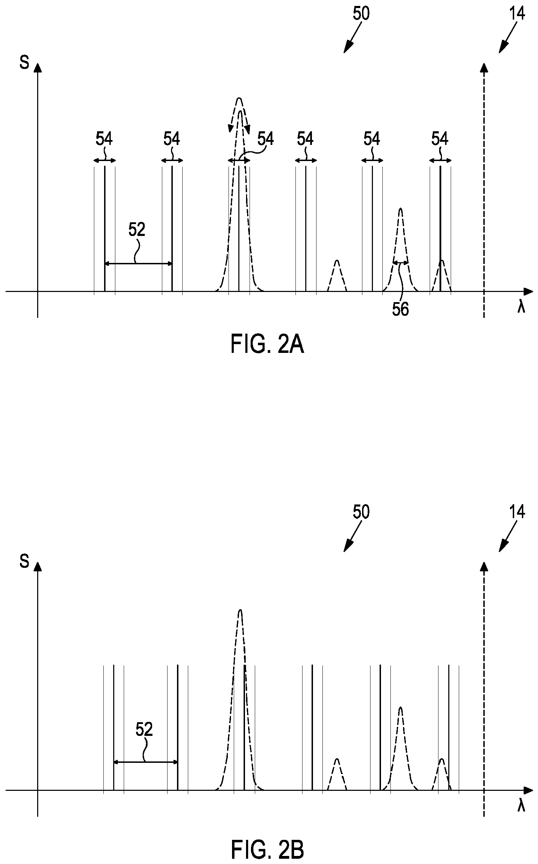

See, for example, FIGS. 2A and 2B.

In examples, the means 18 for changing at least a subset of the plurality of wavelengths of the frequency comb 14 of light are for and/or configured to cooperate with the means 12 for generating a frequency comb 14 of light to generate a frequency comb 14 of light comprising a plurality of shifted wavelengths.

For example, the means 18 for changing at least a subset of the plurality of wavelengths of the frequency comb 14 of light can be for and/or configured to cooperate with and/or affect one or more elements of the means 12 for generating a frequency comb 14 of light to change the plurality of wavelengths of the frequency comb 14 of light.

In examples where the means 12 for generating a frequency comb 14 of light comprises at least one tunable laser 26 and means 28 for manipulating light the means 18 for changing at least a subset of the plurality of wavelengths of the frequency comb 14 of light can comprise means for changing wavelength output 38 of the at least one tunable laser 26 and/or means for tuning 40 the means 28 for manipulating light.

Any suitable means for changing wavelength output 38 of the at least one tunable laser 26 can be used.

In examples, the means for changing wavelength output 38 of the at least one tunable laser 26 can be considered at least one tuner, at least one tuning arrangement, at least one tuning structure, at least one tuning device, at least one tuning apparatus, at least one tuning mechanism, at least one laser output control device, at least one laser output control apparatus, at least one laser control output mechanism, control circuitry, control hardware, and/or control software, and so on.

In examples, the means for changing wavelength output 38 comprises one or more components configured to change wavelength output of the at least one tunable laser 26.

In examples, any suitable means for tuning 40 the means 28 for manipulating light can be used.

In examples, the means for tuning 40 the means 28 for manipulating light can be considered at least one tuner, at least one tuning arrangement, at least one tuning structure, at least one tuning device, at least one tuning apparatus, at least one tuning mechanism, at least one output control device, at least one frequency comb tuning device, at least one control output mechanism, control circuitry, control hardware, and/or control software.

In examples, the means for tuning 40 the means 28 for manipulating light comprise one or more components configured to tune the means 28 for manipulating light.

In examples, the means for tuning 40 the means 28 for manipulating light are for and/or configured to alter the characteristics of the means 28 for manipulating light. In some examples, the means for tuning 40 the means 28 for manipulating light are for and/or configured to alter the response of the means 28 for manipulating light to receiving light from the at least one tunable laser 26.

In some examples, the means for tuning 40 the means 28 for manipulating light are for and/or configured to change the resonance of a micro-resonator 30 of the means 28 for manipulating light.

In some examples, the means for tuning 40 the means 28 for manipulating light are for and/or configured to tune the resonance of a micro-resonator 30 to be operable with the output of the at least one tunable laser 26.

That is, in examples, the means for changing wavelength output 38 of the at least one tunable laser 26 and the means for tuning 40 the means 28 for manipulating light are configured to operate in coordination with each other.

Accordingly, in examples, the means 18 for changing at least a subset of the plurality of wavelengths of the frequency comb 14 of light comprise:
means for changing wavelength output 38 of the at least one tunable laser 26; and
means for tuning 40 the means 28 for manipulating light;
wherein the means for changing wavelength output 38 of the at least one tunable laser 26 and the means for tuning 40 the means 28 for manipulating light are configured to operate in coordination with each other.

In some examples any suitable method for tuning the means 28 for manipulating light can be used. For example, thermo-optic tuning, electro-optic tuning, and/or micro mechanical tuning and so on.

In some examples, changing wavelength output of the at least one tunable laser 26 and/or tuning the means 28 for manipulating light can be done thermally.

Accordingly, in examples, at least one of the means for changing wavelength output 38 of the at least one tunable laser 26 and the means for tuning 40 the means 28 for manipulating light comprises means 42 for controlling temperature.

In examples, any suitable means 42 for controlling temperature can be used.

In some, but not necessarily all, examples, the means 42 for controlling temperature can be considered temperature control means 42.

In examples, the means 42 for controlling temperature can be considered at least one temperature controller, at least one temperature control arrangement, at least one temperature control structure, at least one temperature control device, at least one temperature control apparatus, at least one temperature control mechanism, at least one heater, at least one refrigerator, and/or at least one cooler, and so on.

In examples, the means 42 for controlling temperature comprise one or more components configured to control and/or change the temperature of the at least one tunable laser 26 and/or the means 28 for manipulating light.

For example, the means for tuning the means 28 for manipulating light can comprise at least one heater configured to change the temperature of the means 28 for manipulating light, such as a micro-resonator 30.

In examples, the means for changing wavelength output 38 of the at least one tunable laser 26 can comprise at least one heater configured, for example, to change the temperature of a chip comprising the at least one tunable laser 26.

The at least one acoustic sensor 20 is configured to detect sound produced by analyte 22 illuminated by the frequency comb 14 of light.

The at least one acoustic sensor 20 can comprise any suitable acoustic sensor or acoustic sensors 20.

In examples, the at least one acoustic sensor 20 comprises at least one quartz fork, and/or at least one microphone and/or at least one cantilever and/or at least one suspended waveguide.

In examples, the at least one acoustic sensor 20 can be located at any suitable location(s) in the photoacoustic apparatus 10 to allow the at least one acoustic sensor 20 to detect sound produced by analyte 22 illuminated by the frequency comb 14 of light.

In examples, the at least one acoustic sensor 20 is placed near or proximate or adjacent or in the vicinity of an interaction of analyte 22 and the frequency comb 14 of light in the photoacoustic apparatus 10.

In examples, the photoacoustic apparatus 10 comprises means for spatially and/or temporally separating 44 the plurality of wavelengths of light of the frequency comb 14 into a plurality of sections.

Any suitable means for spatially and/or temporally separating 44 the plurality of wavelengths of light of the frequency comb 14 into a plurality of sections can be used.

In examples, the means for spatially and/or temporally separating 44 the plurality of wavelengths of light of the frequency comb 14 into a plurality of sections can be considered at least one spatial and/or temporal separator, at least one spatial and/or temporal separating arrangement, at least one spatial and/or temporal separating structure, at least one spatial and/or temporal separating device, at least one spatial and/or temporal separating apparatus, and/or at least one spatial and/or temporal separating mechanism and so on.

In examples, the means for spatially and/or temporally separating 44 comprises one or more components configured to spatially and/or temporally separate the plurality of wavelengths of light of the frequency comb 14 into a plurality of sections.

In some examples, the means for spatially and/or temporally separating 44 can comprise at least one wavelength division multiplexor configured to separate the plurality of wavelengths of the frequency comb 14 of light spatially. This can allow photoacoustic measurement to be performed separately on the sections.

See, for example FIG. 4.

Additionally, or alternatively, the means for spatially and/or temporally separating can comprise a tunable bandpass filter configured to separate different sections of the frequency comb 14 of light in time. See, for example, FIG. 5.

In examples at least one dispersive element, at least one diffraction grating, at least one periodic filter and/or at least one arrayed waveguide can be used to spatially and/or temporally separate different sections of the frequency comb 14.

At least some of the various features of the photoacoustic apparatus 10 of FIG. 1 can be considered to be operationally coupled and any number or combination of intervening elements can exist (including no intervening elements).

The photoacoustic apparatus 10 is advantageous as it allows for photoacoustic spectroscopy to be performed over a large range of wavelengths allowing, for example, multiple target molecules to be detected by the photoacoustic apparatus 10.

The photoacoustic apparatus 10 is also advantageous as, for example, it provides for photoacoustic spectroscopy 10 over a wide range of wavelengths while using, for example, a tunable laser 26 that is tunable over a much smaller wavelength range.

The use of such a photoacoustic apparatus 10 can, for example, increase the tunability of a photoacoustic spectroscopy system by a factor of approximately one hundred.

In examples, the photoacoustic apparatus 10 of FIG.1 can comprise any number of additional components, including no additional components.

In some examples, one or more components can be omitted and/or combined. For example, in examples, the means for spatially and/or temporally separating 44 can be omitted. This is illustrated in the example of FIG. 1 by the dashed box around element 44.

FIGS. 2A and 2B illustrate example spectrums of wavelength modulated frequency combs 14. In examples, the spectrums of FIGS. 2A and 2B can be generated/produced by a photoacoustic apparatus 10 as illustrated and/or described herein, for example in relation to at least one of FIGS. 1, 3, 4, 5 or 6.

FIG. 2A illustrates a schematic example representation of a spectrum S of a frequency comb 14 spectrum (left axis of Fig. 2A).

In the example of FIG. 2A the bold lines in between two adjacent outer lines represent the central wavelengths of the modes of the frequency comb 14.

The thinner lines on either side of the mode central wavelength lines represent the extent of the wavelength modulation 54.

The modes of the frequency comb 14 are separated by a gap or free spectral range 52.

In the example of FIG. 2A, the dashed lines represent an example of an absorption spectrum 50 of analyte 22. In the illustrated example analyte 22 is a gas.

If a frequency comb 14 mode coincides with an absorption line of the gas, light will be absorbed and transformed into heat. Modulation of the wavelength modulates the absorption and therefore the production of heat.

The modulated production of heat in turn translates to a modulation of gas pressure, that is a sound, that can be detected by the at least one acoustic sensor 20.

In the example of FIG. 2A it can be seen that the mode of frequency comb third from the left coincides with an absorption line of the gas which results in absorption modulation as illustrated by the dashed double-ended arrow above that absorption line.

Accordingly, in the example of FIG. 2A the analyte 22 illuminated by the frequency comb 14 of light will produce sound due to the modulation of the light.

In examples, the amplitude of the wavelength modulation can be chosen to be in the range of a typical absorption linewidth 56.

In the example of FIG. 2A it can also be seen that the rightmost mode of the frequency comb 14 also coincides with an absorption line of the gas.

In examples, the amplitude of the detected sound is proportional to the sum of the absorption of the analyte 22 at the different wavelengths of the frequency comb 14. In the example of FIG. 2A the sound power is proportional to the sum of the central absorption peak and the small rightmost peak.

Example values for a frequency comb 14 are as follows:
Frequency comb central wavelength: 3 microns
Frequency comb span: 500 nanometers
Free spectral range: 5 nanometers
Number of modes: approximately 100
Modulation amplitude: +/- 50 picometers
Modulation frequency: 1 kilohertz
Typical molecular absorption line width: 0.1cm⁻¹ to 1cm⁻¹

It can be seen from the example of FIG. 2A that all wavelengths of the frequency comb 14 of light are modulated simultaneously at the modulation frequency.

FIG. 2B illustrates a schematic example representation of a spectrum S of a frequency comb 14 spectrum.

The example of FIG. 2B illustrates the frequency comb 14 illustrated in FIG. 2A after the plurality of wavelengths of the frequency comb 14 of light have been changed.

It can be seen from the example of FIG. 2B that the wavelengths of the modes of the frequency comb 14 have moved relative to the absorption spectrum 50 of the gas which is unchanged compared to the example of FIG. 2A.

Accordingly, it can be seen in the example of FIG. 2B that, at the changed wavelengths of the frequency comb 14 of light, different modes of the frequency comb 14 interact with the absorption spectrum 50 of the gas.

For example, the mode third from the left in the illustrated example has shifted relative to the absorption line and therefore the absorption of light at that mode by the absorption line is altered due to the shift.

In addition, the rightmost mode has shifted relative to the small absorption line and the mode second from the right now interacts with the absorption line that is second to the right.

It can therefore be seen in the example of FIG. 2B that by changing the plurality of wavelengths of the frequency comb 14 of light the sound produced by photoacoustic effect is changed due to the shifting of the wavelengths of light relative to the absorption spectrum 50.

That is, in the example of FIG. 2B a different acoustic response will be determined compared to the example of FIG. 2A due to the change in relationship between the modes of the frequency comb 14 and the absorption spectrum 50 between the examples of FIGS. 2A and 2B.

In examples, the measured combined spectrum resulting from modulation of the light of the frequency comb 14 at a plurality of different wavelengths, for example the wavelengths illustrated in FIGS. 2A and 2B, can be used to identify molecular species. Accordingly, this technique can be used to calculate the concentration of different molecular species contained in a sample.

In examples, the measurement of the sound produced is repeated after shifting the modes of the frequency comb 14 of light by small increments until, for example, the free spectral range of the frequency comb 14 of light has been addressed.

In examples, the increments can be chosen to be smaller or in the same range as a typical absorption linewidth.

In the examples illustrated in FIGS. 2A and 2B the increments by which the modes are shifted can be 50 picometers over a total shift of 5 nanometers resulting in 100 measurement points for the gas being sampled.

In this way, the photoacoustic apparatus 10 allows for identification of a range of molecular species due to the tunability of the photoacoustic apparatus 10.

Although FIGS. 2A and 2B have been described in relation to wavelength modulation, in examples, in addition or alternatively, power modulation of the wavelengths of light of the frequency comb 14 can be used.

FIG. 3 illustrates an example of a photoacoustic apparatus 10.

In examples, one or more elements illustrated in FIG. 3 can be as described in relation to FIG. 1.

In the example of FIG. 3, the photoacoustic apparatus 10 comprises a tunable laser 26 configured to provide light to pump means 28 for manipulating light in the form of a micro-resonator 30 to produce a frequency comb 14 of light.

This is illustrated in the example of FIG. 3 by the plot to the right of the tunable laser 26 illustrating a single wavelength in the spectrum of light from the laser 26 and the plot to the right of the micro-resonator 30 illustrating the frequency comb 14 of light after the micro-resonator 30.

In the example of FIG. 3, the light from the tunable laser 26 evanescently couples from a waveguide 62 to the micro-resonator 30.

Cascaded non-linear optical effects such as Kerr effect and four wave mixing generates several other wavelengths in the resonator. The wavelengths are roughly equally spaced by the free spectral range which is inversely proportional to the roundtrip time of the resonator.

The light produced in this way couples back to the waveguide 62 and is guided towards the analyte 22.

In the example of FIG. 3 the tunable laser 26 and micro-resonator 30 are implemented on a single chip 32.

In the example of FIG. 3 the frequency comb 14 of light is directed towards analyte 22 in a gas cell 64 in which the at least one acoustic sensor 20 is located.

In the example of FIG. 3 a gas cell 64 is used, however in examples any suitable means for introducing analyte 22 to be illuminated by the frequency comb 14 of light can be used. For example, any suitable means for introducing analyte 22 into the optical path of the frequency comb 14 of light can be used.

In examples, one or more cells, one or more chambers, one or more containers and/or one or more cavities, and so on, can be used.

In some examples, introducing analyte 22 into the optical path of the frequency comb 14 of light, to allow the analyte 22 to be illuminated by the frequency comb 14 of light, can comprise at least one inlet and at least one outlet to allow fluid, such as gas to be introduced into the optical path of the frequency comb 14 of light.

In examples, the analyte 22 under test comes into contact with the frequency comb 14 of light either because the light propagates in free space at some point in the optical path while the frequency comb 14 of light propagates through analyte 22 which may be in the form of a gas.

However, in some examples, the photoacoustic apparatus 10 does not comprise any particular means for introducing analyte 22 into the optical path of the frequency comb 14 of light, to allow the analyte 22 to be illuminated by the frequency comb 14 of light, but rather, for example, a fluid, such as air, is allowed to penetrate the photoacoustic apparatus 10 to introduce analyte 22 into the optical path of the frequency comb 14 of light, to allow the analyte 22 to be illuminated by the frequency comb 14 of light.

As illustrated in the example of FIG. 3, the frequency comb 14 of light interacts with the absorption spectrum 50 of the analyte 22. Accordingly, when the frequency comb 14 of light is modulated a photoacoustic affect can be achieved.

In some examples the at least one acoustic sensor 20 can also be combined onto a chip with the tunable laser(s) 26 and micro-resonator(s) 30.

In the example of FIG. 3 the photoacoustic apparatus 10 comprises means 34 configured to modulate the wavelength and/or amplitude of the light from the tunable laser 26.

The photoacoustic apparatus 10 of FIG. 3 also comprises a lock-in amplifier 58.

In the illustrated example, the lock-in amplifier 58 measures the output signal of the acoustic sensor at a given frequency, filtering out noise and background generated at different frequencies.

The lock-in amplifier 58 is synchronised with the modulation of the frequency comb 14.

The synchronisation signal used by the lock-in can come from an electrical source also used to modulate the frequency comb 14 or from an electrical or optical measurement of the modulation.

For amplitude modulation, the frequency component selected by the lock-in amplifier 58 is the same as the modulation frequency. For wavelength modulation the selected frequency is a harmonic of the modulation frequency.

In some examples a pre-amplifier will be used between the acoustic sensor and the lock-in amplifier 58.

In the example of FIG. 3, the photoacoustic apparatus 10 also comprises a wave meter 60 to allow a determination of the wavelength of the light from the tunable laser 26. However, in some examples, the wave meter 60 is not included.

In the example of FIG. 3, the tunable laser 26 can be tuned to change the output wavelength of the laser light. For example, the temperature of at least a portion of the chip and/or tunable laser 26 can be changed to change the output of the tunable laser 26.

In the example of FIG. 3 the photoacoustic apparatus 10 comprises means 40 for tuning the means 28 for manipulating light, which in the example of FIG. 3 is a micro-resonator 30.

In the example of FIG. 3 the means 40 for tuning the means 28 for manipulating light is means 42 for controlling temperature in the form of a heater 40.

The heater 40 can be controlled in combination with the tunable laser 26 to shift the frequencies of light in the frequency comb 14 as described in relation to FIGS. 2A and 2B.

Accordingly, by controlling the tunable laser 26 and the heater 40 shifted frequency modes of the frequency comb 14 can be modulated to generate different combined acoustic spectrums.

FIG. 4 illustrates an example of a photoacoustic apparatus 10.

In examples, one or more elements illustrated in FIG. 4 can be as described in relation to FIG. 1 and/or FIG. 3.

The photoacoustic apparatus 10 illustrated in the example of FIG. 4 is similar to photoacoustic apparatus 10 illustrated in the example of FIG. 3.

However, in the example of FIG. 4 the control means 34 are not illustrated.

In addition, in the example of FIG. 4 the photoacoustic apparatus 10 comprises means for spatially and/or temporally separating 44 the plurality of wavelengths of light of the frequency comb 14 into a plurality of sections.

In the example of FIG. 4, the means 44 comprises a wavelength division multiplexor configured to separate spatially the spectrum of the frequency comb 14 of light into separate sections.

This can be seen in the example of FIG. 4 by the three separate cells 64 comprising analyte 22 and being addressed by three separate sections of the spectrum of the frequency comb 14 of light.

Accordingly, in the example of FIG. 4 the absorption spectrum 50 of the analyte 22 is addressed by three, more specific, sections of the frequency comb 14 of light which can be modulated to produce a photoacoustic effect.

This can be beneficial as, because the detected acoustic signal is proportional to the sum of the absorptions at different wavelengths, some information is lost in the process.

Accordingly, in order to reduce the number of wavelengths summed together, it can be beneficial to separate the spectrum of light of the frequency comb 14 into several sections and perform the photoacoustic measurements separately on the sections as illustrated in the example of FIG. 4.

In examples, the spectrum of light of the frequency comb 14 can be separated into any suitable number of sections.

FIG. 5 illustrates an example of a photoacoustic apparatus 10.

In examples, one or more elements illustrated in FIG. 5 can be as described in relation to FIG. 1, FIG. 3 and/or FIG. 4.

The photoacoustic apparatus 10, illustrated in FIG. 5, is similar to the photoacoustic apparatus illustrated in FIG. 4.

However, in the example of FIG. 5 the means for spatially and/or temporally separating 44 the plurality of wavelengths of light of the frequency comb 14 into a plurality of sections is configured to temporally separate wavelengths in the frequency comb 14 of light.

In the example of FIG. 5, the means 44 comprises a tunable bandpass filter, however any suitable means can be used.

It can be seen in the example of FIG. 5 that the tunable bandpass filter 44 can be controlled to allow a first section of the frequency comb 14 of light to pass followed by a second section and then a third section. In this way the frequency comb 14 of light can be split temporally into different sections.

Again, this allows the specificity of the photoacoustic effect to be increased by reducing the number of wavelengths summed together.

In examples, the frequency comb 14 of light can be temporally separated into any suitable number of sections.

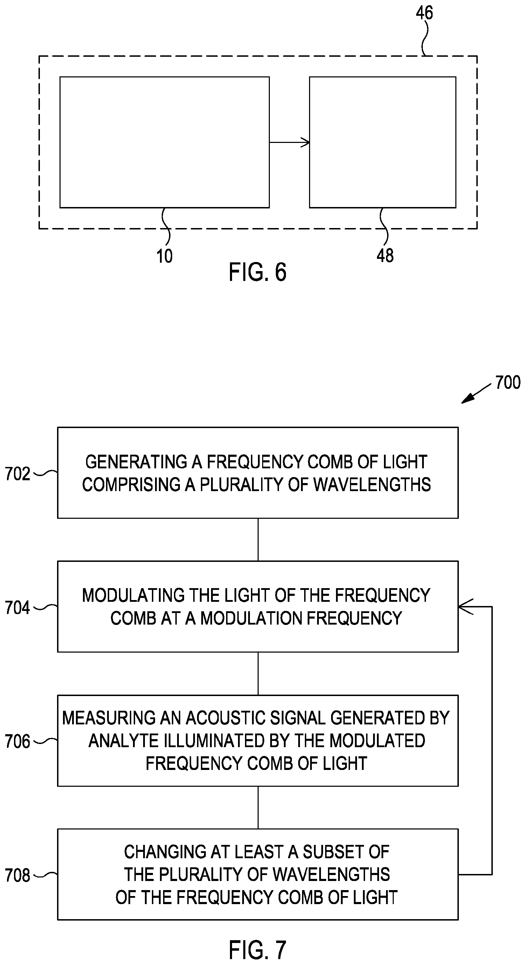

FIG. 6 illustrates an example of a system 46.

In the example of Fig. 6, the system 46 is a system configured to perform photoacoustic spectroscopy. The system 46 of FIG. 6 can therefore be considered to be a photoacoustic spectroscopy system.

In the example of FIG. 6, the system 46 comprises at least one photoacoustic apparatus 10 as described herein. For example, the photoacoustic apparatus 10 can be as described in relation to one or more of FIGS. 1, 3, 4 and/or 5.

In the example of FIG. 6, the system 46 also comprises means for measuring signal output 48 from the at least one acoustic sensor 20.

In examples, any suitable means for measuring signal output from the at least one acoustic sensor 20 can be used.

In examples, the means for measuring signal output from the at least one acoustic sensor 20 can be considered one or more signal measurers, one or more signal measuring arrangements, one or more signal measuring structures, one or more signal measuring devices, one or more signal measuring apparatuses, one or more signal measuring mechanisms, signal measurement hardware, signal measurement software, and/or signal measurement circuitry and so on.

For example, the means 48 can comprise, in examples, one or more electronic devices.

In examples, the system 46 an comprise one or more additional elements not illustrated in Fig. 6.

FIG. 6 therefore illustrates a system 46 comprising:
at least one photoacoustic apparatus 10 as described herein; and
means for measuring signal output from the at least one acoustic sensor 20.

FIG. 7 illustrates an example of a method 700. In examples, the method 700 can be considered a photoacoustic method 700 and/or a photoacoustic spectroscopy method 700.

In examples, the method 700 can be performed by a photoacoustic apparatus 10 as described herein. For example, the method 700 can be performed by a photoacoustic apparatus 10 as described in relation to one or more of FIGS. 1 to 6.

At block 702 a frequency comb 14 of light comprising a plurality of wavelengths is generated.

In examples, any suitable means and/or method for generating a frequency comb 14 of light comprising a plurality of wavelengths can be used. For example, means 12 for generating a frequency comb 14 of light as described in relation to FIG. 1 can be used to generate the frequency comb 14 of light comprising a plurality of wavelengths.

In examples, generating a frequency comb 14 of light comprises controlling at least one tunable laser 26 to supply or pump light to means 28 for manipulating light to generate the frequency comb 14 of light.

In examples, the means 28 for manipulating light comprises at least one micro-resonator 30.

At block 704 the light of the frequency comb 14 is modulated at a modulation frequency.

In some, but not necessarily all, examples, it can be considered that the plurality of wavelengths of light of the frequency comb 14 are modulated at a modulation frequency.

In examples, any suitable means and/or method for modulating the light of the frequency comb 14 at a modulation frequency can be used.

For example, means 16 for modulating the light of the frequency comb 14 as described in relation to FIG. 1 can be used.

Any suitable modulation frequency can be used. In examples, the modulation frequency can comprise a frequency in the range 10Hz to 100kHz.

Modulating the light of the frequency comb 14 can comprise modulating the wavelengths and/or amplitude of the light of the frequency comb 14.

In examples, modulating the light of the frequency comb 14 comprises controlling modulation of drive current and/or power of a tunable laser or lasers.

In some examples modulating light of the frequency comb 14 of light comprises using a modulator configured to receive light and to modulate the light of the frequency comb 14 of light.

In examples all wavelengths of light of the frequency comb 14 are modulated at substantially the same frequency.

In some examples the wavelengths or power of the whole frequency comb 14 is modulated at once to produce a photoacoustic effect.

At block 706 an acoustic signal generated by analyte 22 illuminated by the modulated frequency comb 14 of light is measured.

Any suitable means and/or method for measuring an acoustic signal generated by analyte 22 illuminated by the modulated frequency comb 14 of light can be used.

In examples, one or more acoustic sensors 20 as described in relation to FIG. 1 can be used.

In examples, means for measuring signal output from the at least one acoustic sensor 20 as described in relation to FIG. 6 can be used.

At block 708 at least a subset of the plurality of wavelengths of the frequency comb 14 of light are changed. In examples the plurality of wavelengths of the frequency comb 14 of light can be considered to be moved or shifted.

Any suitable means and/or method for changing at least a subset of the plurality of wavelengths of the frequency comb 14 of light can be used.

For example, means 18 for changing at least a subset of the plurality of wavelengths of the frequency comb 14 of light as described in relation to FIG. 1 can be used to change the plurality of wavelengths of the frequency comb 14 of light.

In examples, the wavelengths of the frequency comb 14 of light can be shifted as described, for example, in relation to FIGS. 2A and 2B.

In some examples, changing at least a subset of the plurality of wavelengths of the frequency comb 14 of light comprises changing, in coordination with each other, wavelength output of at least one tunable laser 26 and tuning of means 28 for manipulating light that generates a frequency comb 14 of light when pumped by the at least one tunable laser 26.

See, for example, FIGS. 3 to 5.

In examples, changing at least a subset of the plurality of wavelengths of the frequency comb 14 of light can be done thermally, for example using means 42 for controlling temperature, such as one or more heaters.

In examples, block 704, 706 and 708 can be iterated as illustrated by the arrow linking block 708 to 704.

That is, in examples, at least a subset of the plurality of wavelengths of the frequency comb 14 of light can be changed, by, for example, shifting the wavelengths, and the changed wavelengths modulated and any acoustic signal generated by analyte 22 in response measured.

The blocks can be iterated any suitable number of times.

In examples, the method 700 can end at block 706 once any required number or iterations has been completed such that the plurality of wavelengths of the frequency comb 14 of light are not further changed.

Accordingly, FIG. 7 illustrates a method 700 comprising:
generating a frequency comb 14 of light comprising a plurality of wavelengths;
modulating the light of the frequency comb 14 at a modulation frequency;
measuring an acoustic signal generated by analyte 22 illuminated by the modulated frequency comb 14 of light;
changing at least a subset of the plurality of wavelengths of the frequency comb 14 of light;
modulating the changed light of the frequency comb 14;
measuring an acoustic signal generated by analyte 22 illuminated by the modulated changed frequency comb 14 of light.

In examples, the method 700 comprises spatially and/or temporally separating the plurality of wavelengths of light of the frequency comb 14 into a plurality of sections.

Any suitable means and/or method for spatially and/or temporally separating the plurality of wavelengths of light of the frequency comb 14 into a plurality of sections can be used.

For example, means for separating 44 as described in relation to FIG 4 and/or FIG 5 can be used.

There is no required or preferred order for the actions of the method and the order and arrangement of the actions can be varied. Furthermore, it may be possible for one or more actions to be varied.

According to some, but not necessarily all, examples of the disclosure there is provided a method of providing a photoacoustic apparatus 10 as described herein. For example, a method of providing a photoacoustic apparatus 10 as described in relation to one or more of FIGS 1 to 6.

In examples, the method comprises:
providing means 12 for generating a frequency comb 14 of light comprising a plurality of wavelengths;
providing means 16 for modulating the light of the frequency comb 14 at a modulation frequency
providing means 18 for changing at least a subset of the plurality of wavelengths of the frequency comb 14 of light; and
providing at least one acoustic sensor 20 configured to detect sound produced by analyte 22 illuminated by the frequency comb 14 of light.

In examples the method comprises providing means for spatially and/or temporally separating the plurality of wavelengths of light of the frequency comb 14 into a plurality of sections.

Any suitable method or methods for providing the components of the photoacoustic apparatus 10 can be used.

For example, the method or methods can comprise any suitable method of manufacturing and/or fabricating and/or locating one or more components of the photoacoustic apparatus.

There is no required or preferred order for the actions of the method and the order and arrangement of the actions can be varied. Furthermore, it may be possible for one or more actions to be varied.

As used in this application, the term 'circuitry' may refer to one or more or all of the following:
(a) hardware-only circuitry implementations (such as implementations in only analog and/or digital circuitry) and
(b) combinations of hardware circuits and software, such as (as applicable):
   (i) a combination of analog and/or digital hardware circuit(s) with software/firmware and
   (ii) any portions of hardware processor(s) with software (including digital signal processor(s)), software, and memory(ies) that work together to cause an apparatus, such as a mobile phone or server, to perform various functions and
(c) hardware circuit(s) and or processor(s), such as a microprocessor(s) or a portion of a microprocessor(s), that requires software (e.g. firmware) for operation, but the software may not be present when it is not needed for operation.
This definition of circuitry applies to all uses of this term in this application, including in any claims. As a further example, as used in this application, the term circuitry also covers an implementation of merely a hardware circuit or processor and its (or their) accompanying software and/or firmware. The term circuitry also covers, for example and if applicable to the particular claim element, a baseband integrated circuit for a mobile device or a similar integrated circuit in a server, a cellular network device, or other computing or network device.

Where a structural feature has been described, it may be replaced by means for performing one or more of the functions of the structural feature whether that function or those functions are explicitly or implicitly described.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one.." or by using "consisting".

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain examples, those features may also be present in other examples whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer an exclusive meaning.

The presence of a feature (or combination of features) in a claim is a reference to that feature or (combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. A photoacoustic apparatus comprising:
means for generating a frequency comb of light comprising a plurality of wavelengths;
means for modulating the light of the frequency comb at a modulation frequency;
means for changing at least a subset of the plurality of wavelengths of the frequency comb of light; and
at least one acoustic sensor configured to detect sound produced by analyte illuminated by the frequency comb of light.

2. A photoacoustic apparatus as claimed in claim 1, wherein the means for modulating the light of the frequency comb comprises means for modulating the wavelengths and/or amplitude of the light of the frequency comb.

3. A photoacoustic apparatus as claimed in claim 1 or 2, wherein the means for generating a frequency comb of light comprises at least one tunable laser and means for manipulating light, and wherein the at least one tunable laser is configured to pump the means for manipulating light to generate the frequency comb of light.

4. A photoacoustic apparatus as claimed in claim 3, wherein the means for manipulating light comprises at least one micro-resonator.

5. A photoacoustic apparatus as claimed in claim 3 or 4, wherein the means for generating a frequency comb of light comprises a single tunable laser and a single micro-resonator.

6. A photoacoustic apparatus as claimed in claim 3, 4 or 5, wherein the at least one tunable laser and the means for manipulating light are combined on a single chip.

7. A photoacoustic apparatus as claimed in any of claims 3 to 6, wherein the means for modulating the light of the frequency comb comprises means for controlling modulation of drive current and/or power of the tunable laser or lasers.

8. A photoacoustic apparatus as claimed in any preceding claim, wherein the means for modulating the light of the frequency comb comprises at least one modulator configured to receive light and to modulate the light of the frequency comb of light.

9. A photoacoustic apparatus as claimed in any of claims 3 to 8, wherein the means for changing at least a subset of the plurality of wavelengths of the frequency comb of light comprises:
means for changing wavelength output of the at least one tunable laser; and
means for tuning the means for manipulating light;
wherein the means for changing wavelength output of the at least one tunable laser and the means for tuning the means for manipulating light are configured to operate in coordination with each other.

10. A photoacoustic apparatus as claimed in claim 9, wherein at least one of the means for changing wavelength output of the at least one tunable laser and the means for tuning the means for manipulating light comprises means for controlling temperature.

11. A photoacoustic apparatus as claimed in any preceding claim, comprising means for spatially and/or temporally separating the plurality of wavelengths of light of the frequency comb into a plurality of sections.

12. A photoacoustic apparatus as claimed in any preceding claim, wherein the means for modulating the light of the frequency comb are configured to modulate all wavelengths of light of the frequency comb at substantially the same frequency.

13. A system comprising:
at least one photoacoustic apparatus as claimed in any preceding claim; and
means for measuring signal output from the at least one acoustic sensor.

14. A method comprising:
generating a frequency comb of light comprising a plurality of wavelengths;
modulating the light of the frequency comb at a modulation frequency;
measuring an acoustic signal generated by analyte illuminated by the modulated frequency comb of light;
changing at least a subset of the plurality of wavelengths of the frequency comb of light;
modulating the changed light of the frequency comb;
measuring an acoustic signal generated by analyte illuminated by the modulated changed frequency comb of light.

15. The method of claim 14 wherein changing at least a subset of the plurality of wavelengths of the frequency comb of light comprises changing, in coordination with each other, the wavelength output of at least one tunable laser and tuning of the means for manipulating light that generates a frequency comb of light when pumped by the at least one tunable laser.
